# EUROPÄISCHE PATENTSCHRIFT

(11) **EP 0 397 176 B1**
(45) Veröffentlichungstag und Bekanntmachung des Hinweises auf die Patenterteilung: **19.10.1994**
(21) Anmeldenummer: 90108829.4
(22) Anmeldetag: 10.05.1990
(51) Int. Cl.: H02M 3/335, H02M 7/08

(54) **Schaltnetzteil zum Betreiben eines Magnetrons**
Switching power supply for operating a microwave oven
Alimentation de puissance à découpage pour mettre en oeuvre un magnétron

(30) Priorität: 12.05.1989 DE 3915540
(43) Veröffentlichungstag der Anmeldung: 14.11.1990
(73) Patentinhaber: VOGT electronic Aktiengesellschaft, D-94128 Obernzell (DE)
(72) Erfinder: Hartmann, Uwe, D-8391 Untergriesbach (DE); Mai, Udo, D-8391 Untergriesbach (DE)
(74) Vertreter: Hieke, Kurt

(56) Entgegenhaltungen:
- DE-A- 3 644 012
- GB-A- 2 006 552
- US-A- 4 455 596

## Beschreibung

Die Erfindung bezieht sich auf ein Schaltnetzteil zum speisen eines Magnetrons.

Gegenüber Netzteilen in der 50 Hz-Technik haben Schaltnetzteile zum Betreiben eines Magnetrons eine Reihe von Vorteilen, die die Leistungssteuerung sowie die Konstanz der vorgegebenen Dosierungsenergie betreffen.

Unter Berücksichtigung der gesetzlichen Vorschriften (VDE 0838 bzw. EN 60555, Teil 2 und 3) und der elektrischen Daten des Magnetrons ergibt sich jedoch mit der bisherigen Technik die Schwierigkeit, den für die maximale Leistung erforderlichen Strom von derzeit etwa 350 mA (analytischer Mittelwert) durch unipolare Stromimpulse mit einem zulässigen Spitzenwert von 1,2 A zu erreichen.

Aus der US - 4 45 55 96 ist ein Schaltnetzteil bekannt, das zwei Sekundärwicklungen aufweist, die so bewickelt und beschaltet sind, daß die eine während der Durchflußphase und die andere während der Sperrphase Energie an ihre zugeordnete Last abgibt.

Der Erfindung liegt die Aufgabe zugrunde, ein Schaltnetzteil zu schaffen, bei dem die vorstehend geschilderte Schwierigkeit eliminiert ist.

Die vorgenannte Aufgabe wird durch die im Patentanspruch 1 genannten Merkmale gelöst.

Durch die im Patentanspruch 1 angegebenen Merkmale wird die Anzahl der Strompulse bezogen auf einen Zeitabschnitt - z.B. eine Netzperiode - gegenüber der bisherigen Technik verdoppelt, was die Aufgabenstellung des Höchstleistungsbetriebes mit gepulsten Strömen erheblich erleichtert oder sogar erst ermöglicht.

Die Unteransprüche betreffen bevorzugte Ausgestaltungen des Schaltnetzteils gemäß Patentanspruch 1.

Nachstehend wird anhand der Zeichnung ein bevorzugtes Ausführungsbeispiel eines Schaltnetzteils gemäß der Erfindung näher erläutert. In der Zeichnung zeigt:
- Bild 1: das Gesamtschaltbild des Schaltnetzteils,
- Bild 2a und 2b: schematisch die Funktion des Auskopplungskreises für die alternierende Betriebsart (Sperrwandler- bzw. Durchflußbetrieb), und
- Bild 3a-3k: die Strom- und Spannungsverhältnisse während des Betriebes mit maximaler Leistung.

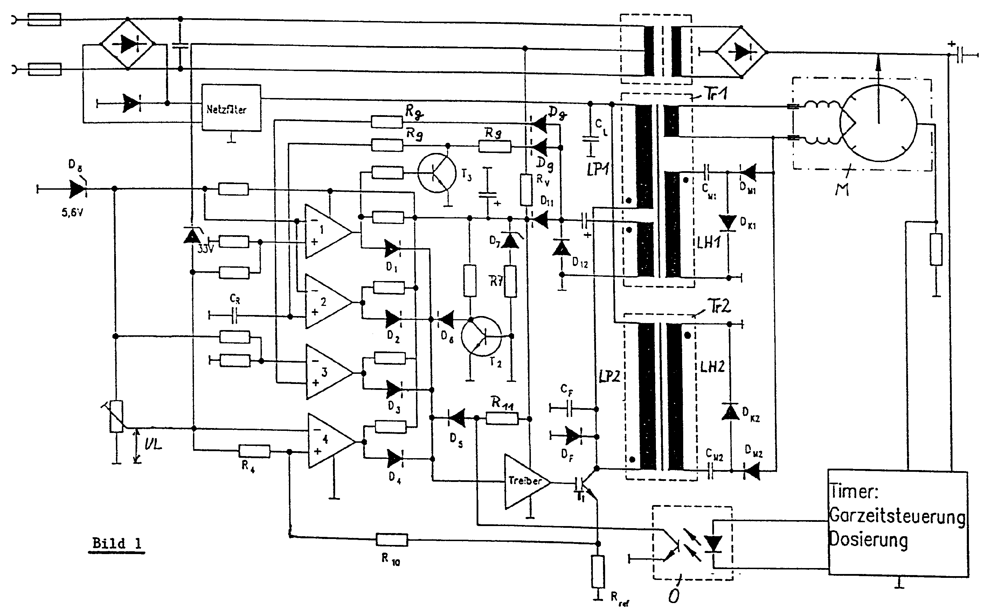

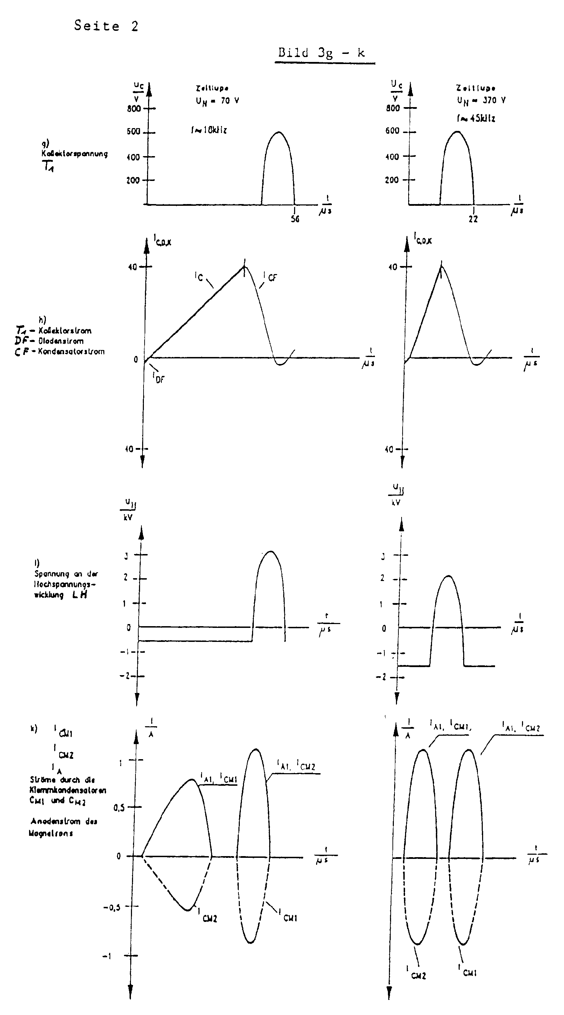

Im Bild 3a sind jeweils für eine halbe Netzperiode unterschiedliche Netzspannungen (190V∼,220V∼ und 264V∼) dargestellt, und Bild 3b zeigt die von der Netzspannung abhängige zugehörige Stromaufnahme. In den Bildern 3c, 3d und 3e sind als Pakete der Kollektorstrom des Schalttransistors T1 des Schaltnetzteils gemäß Bild 1, der Strom durch die Diode DS sowie die Kollektorspannung des Schalttransistors T1 wiedergegeben. Die Paketbreite (prozentualer Anteil der Gesamtstromflußzeit) wird im Betrieb mit maximaler Leistung nur durch die Netzaugenblicksspannung bestimmt. Im Vorheizbetrieb wird sie zusätzlich durch die Rampenspannung am Kondensator CR der Schaltung gemäß Bild 1 begrenzt. Im Normalbetrieb erreicht die Rampenspannung (Bild 3f) nicht die Abschaltschwelle der Zenerdiode D8 (5,6V).

In den Bildern 3a bis 3f sind Zeitlupendarstellungen für die Fälle der Netzaugenblicksspannungen 70V und 370V (264V x √2) wiedergegeben.

Die Endstufe gemäß Bild 1 arbeitet im Sperrwandler-, Durchflußwandler- und Paketbetrieb. Die Freilaufzeit ist abgestimmt (Resonanzkreis: Kondensator CF parallel zur Speicherinduktivität LP1, LP2). Die Freilauffrequenz ist etwa 42kHz, d.h. die Freilaufzeit beträgt etwa 12 µs (Halbsinus). Die Kollektorspannung an dem Schalttransistor T1 ist auf 800 V konstant gehalten.

Die Leitzeit des Schalttransistors T1 ist in Abhängigkeit von der Netzaugenblicksspannung unterschiedlich (etwa 42 µs bei 70 V und 8 µs bei 370 V).

Es wird erreicht, daß am Ende der Leitzeit eine immer etwa gleich große Energie in der Speicherspule LP1, LP2 vorhanden ist, die nach dem Abschalten zum Teil in den Kondensator CF transferiert wird.

Der Schalttransistor T1 ist immer abgeschaltet (Treibereingang = high):
- wenn die Treiberspannung ≦ 10V ist,
   (Funktion: D7, R7, T2 und D6)
- wenn die Spannung an Rref (∼ Kollektorstrom) ≧ UL (Referenzspannung) ist,
   (Funktion: Komparator 4, D4)
- wenn die Rampenspannung an CR ≧ 5,6V (UD8) ist; dieser Betrieb ist nur während der Vorheizzeit (und im Fehlerfall) gegeben,
   (Funktion: Komparator 3, D2)
- wenn die augenblickliche Netzspannung an CL ≦ 70V beträgt,
   (Funktion: Komparator 1, D1)
- während der Fly-back-Phase,
   (Funktion: Dg, Rg, Komparator 3, D3),
- während der Sperrphase des Transistors im Optokoppler 0 (ausgeschalteter Zustand),
   (Funktion: D5, R11 und Optokoppler)

Die Frequenz ist abhängig von der Netzaugenblicksspannung. Eine Periode besteht aus den Zeiten: Einschaltzeit (TE), Freilaufzeit (TF) und Stromzeit (TDF) durch die Energierücklieferdiode DF. Die Einschaltzeit variiert zwischen 8 µs und 42 µs. Die Freilaufzeit ist konstant 12 µs lang. Die Stromflußzeit durch DF ist während der Vorheizzeit fast genau so lang wie die Einschaltzeit. Während dieser Zeit wird abzüglich der Heizenergie die gesamte gespeicherte Energie -nachdem sie von CF wieder in die Speicherinduktivität LP1, LP2 übergegangen ist-über DF in den Ladekondensator CL zurückgeliefert. Im Normalbetrieb ist nur ein kleiner Rest von Energie übrig (Bilder 3g und 3h), da fast die gesamte Energie dem Magnetron M abgegeben wird. Die Stromflußzeit von DF ist dabei nur ca. 3 µs. Die Gesamtperiodenzeit des Normalbetriebes (TE + TF + TdF) schwankt somit zwischen 22 µs und 56 µs.

Das entspricht einer Frequenzvariation von 45 Khz bis 18 kHz im Normalbetrieb. Im Vorheizbetrieb liegt sie zwischen ca. 12 kHz und 38 kHz.

### Die Stromspeisung des Magnetrons M

Wegen seiner Kennlinie (sie entspricht einer 4kV-Zenerdiode) benötigt das Magnetron M eine Stromspeisung. Wenn jedoch die EMK des Generators stabil ist, muß der Generatorinnenwiderstand nur Toleranzen des Magnetrons ausgleichen. Die Bilder 3i und 3k veranschaulichen die Funktion der Magnetronspeisung: Die Spannung an den Hochspannungswicklungen LH1, LH2 ist im Leerlauf (Vorheizzeit) etwa 8 kVss und im Normalbetrieb -durch das Magnetron und die Streuinduktivität Lσ der Trafos begrenztca. 4 kVss (Bild 3i). In Abhängigkeit der Transistorleitzeit des Schalttransistors T1 ist der negative Anteil dieser Spannung unterschiedlich. Die Klemm-oder Gleichsspannungsverdopplerschaltungen, bestehend aus CM1(2) und DM1(2), bewirken unipolare Anodenspannungen an den Dioden DK1 und DK2.

Wie erwähnt, ist es ein Problem, den geforderten großen analytischen Strom von 350 mA (oder in Zukunft mehr) aus Impulsströmen von maximal 1,2 A mit einer großen Zeitspanne von Pausen zu realisieren.

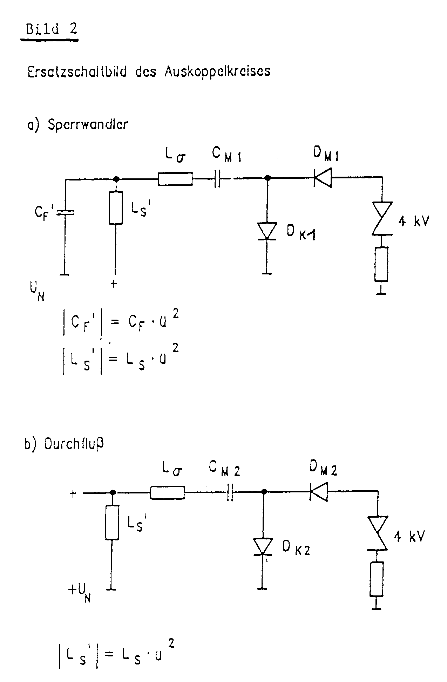

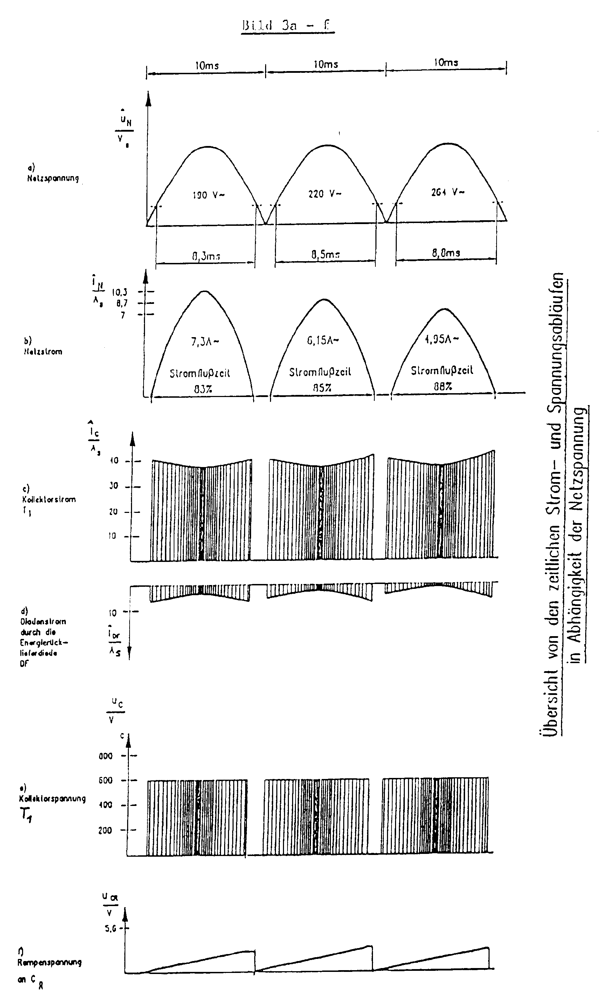

Zur Lösung dieses Problems erlaubt das erfindungsgemäße Konzept die Stromspeisung während der Schalttransistorstromfluß- und der Freilaufzeit durch einen Gegentakt-Klemmbetrieb. Hierdurch werden die Pausenzeiten während des Paketbetriebes halbiert, bzw. die Anzahl der Strompulse verdoppelt. Ermöglicht wird die Gegentaktklemmung durch folgende Eigenschaften:
1. Stabilisierte Wechselspannung (EMK)
2. Der sehr stark durch das Magnetron M bedämpfte Auskopplungsreihenkreis. Er besteht im wesentlichen aus der transformierten Speicherinduktivität LS' (Bild 2) zuzüglich der großen Streuinduktivität Lσ und den Kondensatoren CM1(2). (Nur die große Streuinduktivität erlaubt die starke Bedämpfung, Bild 2a,2b).
3. Die Wahl der Freilaufzeit im Vergleich zur Schalttransistorleitzeit plus der Energierücklieferzeit. Die Freilaufzeit ist im oberen Netzaugenblicksspannungsbereich etwas kürzer und im unteren länger als die Summe der beiden anderen Zeiten.

Das Bild 3k veranschaulicht den Stromfluß der Gegentaktklemmung. Die Bilder 2a und 2b zeigen die entsprechenden Ersatzschaltbilder für den Durchfluß- und Sperrwandlerbetrieb.

CM1 wird während der Sperrphase (Freilaufzeit) und CM2 während der Durchflußphase (Leit- und Energielieferzeit) nachgeladen. Diese erhaltenen Energien geben CM1 während der Durchflußphase und CM2 während der Sperrphase wieder ab. Während dieser Zeiten liefert auch LS' (Bild 2) Energie ins Magnetron M. Während der Sperrphase: im wesentlichen die Energie, die nach dem Abschalten von T1 in der Speicherspule enthalten ist, abzüglich der Energie, die am Ende der Freilaufzeit noch in der Speicherspule vorhanden ist und während der Durchflußphase im Vorwärtsbetrieb.

Ob der Energieanteil, z.B. der Durchflußphase, zuerst in CM gespeichert wird und darauffolgend in der Sperrphase zusammen mit dem entsprechenden Energieanteil ins Magnetron M geleitet wird oder umgekehrt, die Reihenfolge des Energietransfers ist für die Gesamtmenge bedeutungslos. Wichtig ist, daß eine zeitliche Verschachtelung stattfindet, wodurch, wie erwähnt, die Pausenzeiten halbiert werden.

Das Schaltbild gemäß Bild 1 zeigt eine Lösung mit zwei Transformatoren Tr1,Tr2. Diese Lösung hat wirtschaftliche Gründe. Die beschriebene Funktion der Verschachtelung ist auch mit einem einzigen Trafo, der zwei gegenphasige Hochspannungswicklungen LH1, LH2 und nur eine Primärinduktivität LP aufweist, zu erreichen.

Das Ersatzschaltbild des Auskoppelkreises (Bild 2) verdeutlicht auch eine Rückwirkung auf die Spannung am Kondensator CF durch den Anodenstrom des Magnetrons M. Die Spannung an CF und somit alle Wicklungsspannungen werden ohne Magnetronlast höher. Damit das Magnetron M während der Vorheizzeit nicht überheizt wird, sorgt die Rampenspannung am Kondensator CR (Funktion D9, R9 und CR sowie Komparator 2 und D2 ) für eine automatische Verkürzung der Pakete. Die Verkürzung ist stark abhängig von den Trafokopplungseigenschaften.

## Patentansprüche

1. Im Currentmode-, Durchflußwandler- und Sperrwandlerbetrieb arbeitendes, zum Speisen eines Magnetrons einsetzbares Schaltznetzteil, das mit einer Transformatoranordnung (T1, T2) versehen ist, die für die Energieübertragung mindestens eine Primärwicklung (LP1, LP2) und zwei Sekundärwicklungen (LH1, LH2) aufweist, das ferner mittels eines Resonanzkreises aus der/den Primärwicklung(en) (LP1, LP2) und einer diesen zugeordneten Kapazität (C_{F}) eine feste Freilaufzeit hat und bei dem die während der Durchflußzeit nicht entnommene Energie wieder in den Ladekondensator (C_{L}) zurückgespeist wird, wobei zur impulsförmigen Stromauskopplung aus den Sekundärwicklungen (LH1, LH2) zwei für einen Betrieb im Gegentakt geschaltete Klemmschaltungen (CM1, DK1; CM2, DK2) aus einem Kondensator und einer Diode jeweils derart an diese Sekundärwicklungen (LH1, LH2) angeschlossen sind, daß in der Sperrphasenzeit die erste Klemmschaltung (CM1, DK1) den zugehörigen Klemmkondensator (CM1) auflädt während die zweite Klemmschaltung (CM2, DK2) die Energie aus dem zugehörigen Klemmkondensator (CM2) an das Magnetron (M) abgibt, und dann in der darauffolgenden Durchflußphasenzeit die erste Klemmschaltung (CM1, DK1) aus dem zugehörigen Klemmkondensator (CM1) Energie an das Magnetron (M) abgibt, während die zweite Klemmschaltung (CM2, CK2) den zugehörigen Klemmkondensator (CM2) auflädt, und während dieser Phasenzeiten über die Sekundärwicklungen auch direkt Energie in das Magnetron (M) eingespeist wird.

2. Schaltnetzteil nach Anspruch 1, **dadurch gekennzeichnet,** daß zwei Transformatoren (Tr1, Tr2) verwendet werden, deren Primärwicklungen (LP1; LP2) parallel geschaltet sind.

3. Schaltnetzteil nach Anspruch 1, **dadurch gekennzeichnet**, daß ein Transformator verwendet wird, der zwei gegenphasige Hochspannungswicklungen und eine Primärwicklung aufweist.

4. Schaltnetzteil nach einem der vorhergehenden Ansprüche, **dadurch gekennzeichnet,** daß die zur Strombegrenzung erforderliche Längsinduktivität durch die Streuinduktivität (Lσ) des Transformators/der Transformatoren (TR1, TR2) gebildet wird.

## Claims

1. Switching power supply unit which works in current mode operation, flow transformer operation and blocking transformer operation, is usable for the supply of a magnetron and is provided with a transformer arrangement (T1, T2), which has at least one primary winding (LP1, LP2) and two secondary windings (LH1, LH2) for the energy transmission, which further has a fixed freewheel time by means of a resonant circuit consisting of the primary winding or windings (LP1, LP2) and a capacitance (C_{F}) associated therewith and in which the energy not removed during the flow time is fed back again into the charging capacitor (C_{L}), wherein for pulse-shaped current coupling out from the secondary windings (LH1, LH2) two clamping circuits (CM1, DK1; CM2, DK2) wired for an operation in phase opposition and consisting of a capacitor and a diode are each connected to a respective one of these secondary windings (LH1, LH2) in such a manner that in the blocking phase time the first clamping circuit (CM1, DK1) charges up the associated clamping capacitor (CM1) while the second clamping circuit (CM2, DK2) delivers the energy from the associated clamping capacitor (CM2) to the magnetron (M), and then in the flow phase time following thereon the first clamping circuit (CM1, DK1) delivers energy from the associated clamping capacitor (CM1) to the magnetron (M) while the second clamping circuit (CM2, CK2) charges up the associated clamping capacitor (CM2), and during these phase times direct energy is also fed into the magnetron (M) by way of the secondary windings.

2. Switching power supply unit according to claim 1, characterised thereby that two transformers (Tr1, Tr2) are used, the primary windings (LP1; LP2) of which are connected in parallel.

3. Switching power supply unit according to claim 1, characterised thereby that one transformer is used, which has two oppositely-phased high voltage windings and a primary winding.

4. Switching power supply unit according to one of the preceding claims, characterised thereby that the series inductance required for current limitation is formed by the stray inductance (Lσ) of the transformer or transformers (TR1, TR2).

## Revendications

1. Bloc d'alimentation à découpage, travaillant selon le mode de courant, en transducteur conducteur et en transducteur bloqué et utilisé pour l'alimentation d'un magnétron et qui comporte un dispositif à transformateurs (T1, T2), qui possède, pour la transmission de l'énergie, au moins un enroulement primaire (LP1, LP2) et deux enroulements secondaires (LS1, LS2), et qui présente en outre un temps fixe de fonctionnement en roue libre, grâce à la présence d'un circuit résonnant constitué par le/les enroulement(s) primaire(s) (LP1, LP2) et une capacité (C_{F}) associée à ce ou ces enroulements, et dans lequel l'énergie non prélevée pendant le temps de conduction est renvoyée à nouveau dans le transducteur de charge (C_{L}), et dans lequel, pour le découplage de courant sous forme impulsionnelle à partir des enroulements secondaires (LH1, LH2), deux circuits de blocage (CM1, DK1; CM2, DK2), qui sont branchés en position de phase pour le fonctionnement et sont constitués par un condensateur et une diode, sont raccordés à ces enroulements secondaires (LH1, LH2), respectivement de telle sorte que pendant la durée de la phase de blocage, le premier circuit de blocage (CM1, DK1) charge le condensateur de blocage associé (CM1), tandis que le second circuit de blocage (CM2, DK2) envoie l'énergie provenant du condensateur de blocage associé (CM2) au magnétron (M), et ensuite, pendant la durée suivante de la phase de conduction, le premier circuit de blocage (CM1, DK1) envoie une énergie au magnétron (M) à partir du condensateur de blocage associé (CM1), tandis que le second circuit de blocage (CM2, CK2) charge le condensateur de blocage associé (CM2) et, pendant les durées de ces phases, une énergie est également introduite directement dans le magnétron (M) par l'intermédiaire des enroulements secondaires.

2. Bloc d'alimentation à découpage suivant la revendication 1, caractérisé par le fait qu'on utilise deux transformateurs (Tr1, Tr2), dont les enroulements primaires (LP1; LP2) sont branchés en parallèle.

3. Bloc d'alimentation à découpage suivant la revendication 1, caractérisé par le fait qu'on utilise un transformateur, qui possède deux enroulements à haute tension en opposition de phase et un enroulement primaire.

4. Boc d'alimentation à découpage suivant l'une des revendications précédentes, caractérisé par le fait que l'inductance longitudinale nécessaire pour la limitation du courant est formée par l'inductance de fuite (Ls) du transformateur/des transformateurs (TR1, TR2).
